**Europäisches Patentamt**

(19) **European Patent Office**

**Office européen des brevets**

(11) Veröffentlichungsnummer: **0 027 204**

**A1**

(12) # EUROPÄISCHE PATENTANMELDUNG

(21) Anmeldenummer: **80105900.7**

(22) Anmeldetag: **29.09.80**

(51) Int. Cl.³: **G 01 P 3/48**
**G 01 R 23/06, G 01 R 23/02**

(30) Priorität: **10.10.79 DE 2941106**

(43) Veröffentlichungstag der Anmeldung:
**22.04.81 Patentblatt 81/16**

(84) Benannte Vertragsstaaten:
**CH DE FR GB IT LI**

(71) Anmelder: **SIEMENS AKTIENGESELLSCHAFT Berlin
und München
Postfach 22 02 61
D-8000 München 22(DE)**

(72) Erfinder: **Blümner, Christoph, Dipl.-Ing.
Tilman Riemenschneider Strasse 68
D-8552 Höchstadt(DE)**

(72) Erfinder: **Hübner, Klaus, Dipl.-Ing.
Richard-Strauss-Strasse 39
D-8552 Höchstadt(DE)**

(72) Erfinder: **Zander, Hans-Hermann, Dipl.-Ing.
Würzburger Ring 86
D-8520 Erlangen(DE)**

(54) **Drehfrequenz-Spannungs-Umsetzer.**

(57) Die Erfindung betrifft einen Drehfrequenz-Spannungs-Umsetzer zur Ableitung einer drehfrequenzproportionalen elektrischen Spannung aus drehfrequenten Impulsen eines Impulsgebers (13), der mit einer Drehwelle gekoppelt ist. Solche Umsetzer sind als Istwertgeber für die Drehzahlsteuerung elektrischer Drehfeldmaschinen, beispielsweise von Stromrichtermotoren, erforderlich. Dabei ist es wichtig, ein praktisch fehlerfreies drehfrequenzproportionales Analogsignal zu erhalten. Bei dem erfindungsgemäßben Umsetzer ist der Ausgang eines Taktimpulsgebers (1) mit dem Eingang (3a) eines Zählers (3) verbunden, dessen Ausgang (3b) der Eingang eines Speichers nachgeschaltet ist. Der Rücksetzeingang (3c) des Zählers (3) und der Setzeingang (4a) des Speichers (4) sind mit dem Ausgang des Impulsgebers (13) verknüpft. Der Ausgang (4b) des Speichers (4) ist mit dem Eingang eines Digital-Analog-Wandlers (5) verbunden, dessen Widerstandsnetzwerk zwischen den Ausgang (8a) und den invertierenden Eingang (8b) eines Operations verstärkers (8) geschaltet ist. Am Ausgang (8a) des Operationsverstärkers (8) steht die frequenzproportionale Spannung an. Der invertierende Eingang (8b) des Operationsverstärkers (8) ist über einer Widerstand (9) mit einer Referenzspannungsquelle verbunden. Bei dem Umsetzer entspricht der Zählerstand der Drehperiodendauer. Mit Hilfe des in den Gegenkopplungszweig (6) des Operationsverstärkers (8) geschalteten multiplizierenden Digital-Analog-Wandlers (5) wird die Referenzspannung (UR) durch die der Drehperiodendauer (TM) entsprechende Zahl dividiert, womit die Ausgangsspannung des Operationsverstärkers der Drehfrequenz proportional ist.

FIG 1

SIEMENS AKTIENGESELLSCHAFT     Unser Zeichen
Berlin und München            VPA 79 P 3 2 0 0 EUR

**Drehfrequenz-Spannungs-Umsetzer**

Die Erfindung betrifft einen Drehfrequenz-Spannungs-Umsetzer zur Ableitung einer drehfrequenzproportionalen elektrischen Spannung aus drehfrequenten Impulsen eines Impulsgebers, der mit einer Drehwelle gekoppelt ist.

Für die Drehzahlsteuerung elektrischer Drehfeldmaschinen, beispielsweise von Stromrichtermotoren, sind solche Drehfrequenz-Spannungs-Umsetzer als Istwertgeber erforderlich. Bei im Handel erhältlichen Umsetzern ist der Impulsgeber eine Tachomaschine, die mit der Motorwelle gekoppelt ist. Solche Tachomaschinen müssen justiert werden, was die Montage und die Wartung erschwert. Außerdem besitzen sie einen Temperaturgang, der zu einer Istwertverfälschung führen kann. Bei anderen, bekannten Umsetzern wird ein Frequenz-Spannungs-Wandler eingesetzt, der Spannungszeitflächen mittelt. Bei dieser Vorrichtung werden entweder eine hohe Eingangsfrequenz oder hohe Glättungszeitkonstanten benötigt, um die Welligkeit der Ausgangsspannung klein zu halten.

Soe 2 Bim / 08.10.1979

- 2 -     VPA 79 P 3 2 0 0 EUR

Es besteht die Aufgabe, einen Drehfrequenz-Spannungs-Umsetzer der eingangs genannten Art so auszugestalten, daß mit einfachen Mitteln ein praktisch fehlerfreies drehfrequenzproportionales Analogsignal erhalten wird.

Erfindungsgemäß wird diese Aufgabe dadurch gelöst, daß der Ausgang eines Taktimpulsgebers mit dem Eingang eines Zählers verbunden ist, dessen Ausgang der Eingang eines Speichers nachgeschaltet ist, daß der Rücksetzeingang des Zählers und der Setzeingang des Speichers mit dem Ausgang des Impulsgebers verknüpft sind, daß der Ausgang des Speichers mit dem Eingang eines Digital-Analog-Wandlers verbunden ist, dessen Widerstandsnetzwerk zwischen den Ausgang und den invertierenden Eingang eines Operationsverstärkers geschaltet ist, an dessen Ausgang die drehfrequenzproportionale Spannung ansteht und daß der invertierende Eingang des Operationsverstärkers über einen Widerstand mit einer Referenzspannungsquelle verbunden ist.

Bei dem erfindungsgemäßen Umsetzer entspricht der Zählerstand der Drehperiodendauer. Mit Hilfe des in den Gegenkopplungszweig des Operationsverstärkers geschalteten multiplizierenden Digital-Analog-Wandlers herkömmlicher Bauart wird die Referenzspannung durch die der Drehperiodendauer entsprechende Zahl dividiert, womit die Ausgangsspannung des Operationsverstärkers der Drehfrequenz proportional ist. Damit entfällt beispielsweise bei drehzahlgesteuerten elektrischen Maschinen die gesonderte Tachomaschine, da als Impulsgeber der ohnehin erforderliche Rotorlagegeber benützt werden kann.

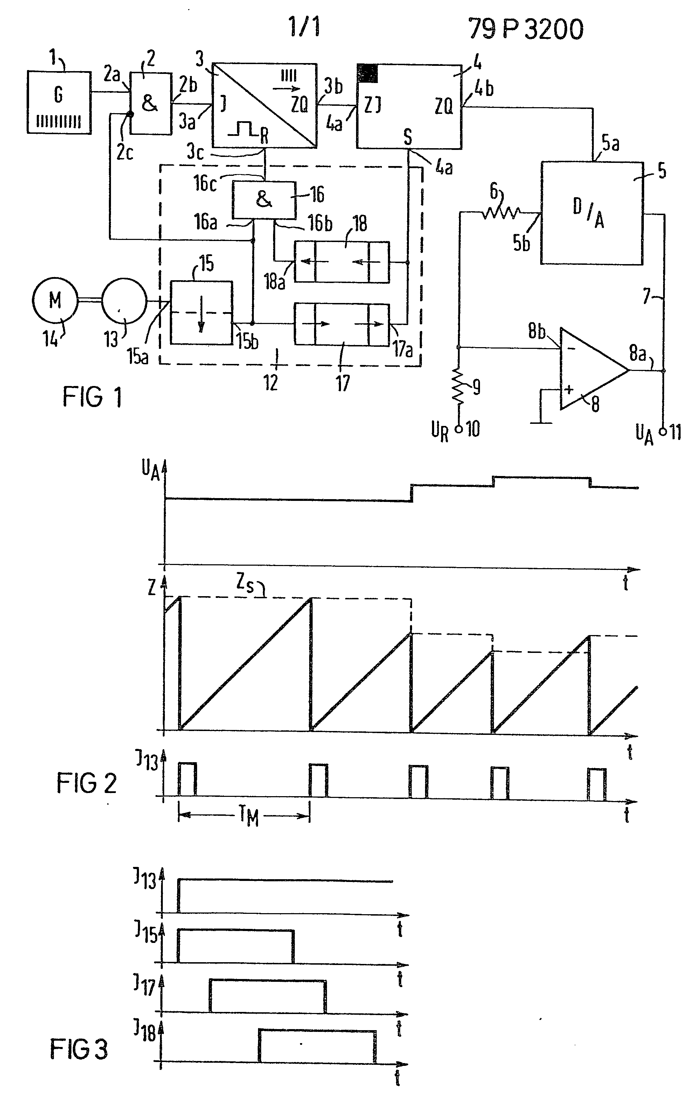

Die erfindungsgemäße Schaltungsanordnung wird beispielhaft anhand der Figuren 1 bis 3 näher erläutert.

- 3 -     VPA 79 P 3 2 0 0 EUR

Figur 1 zeigt das Schaltbild eines erfindungsgemäßen Umsetzers. Der Ausgang eines Taktimpulsgebers 1 ist mit dem Eingang 2a eines UND-Gatters 2 verbunden, dessen Ausgang 2b der Eingang 3a eines Vorwärtszählers 3 nachgeschaltet ist. Die Impulsfrequenz des Taktimpulsgebers 1 ist etwa um den Faktor $10^3$ größer als die Drehfrequenz. Die Ausgänge 3b des Zählers 3 sind mit den Eingängen 4a eines Speichers 4 verbunden. Über die Ausgänge 4b des Speichers 4 werden die Eingänge 5a eines multiplizierenden Digital-Analog-Wandlers 5 angesteuert. Solche multiplizierende Digital-Analog-Wandler herkömmlicher Bauart mit einem über FET-Schalter veränderlichem Widerstandsnetzwerk sind beispielsweise in U. Tietze und Ch. Schenk "Halbleiter-Schaltungstechnik", 1974, Seiten 594 bis 604 und in R. Hahn "Elektronische Bausteinsysteme SIMATIC", Band 1, 1974, Seiten 198 und 199 ausführlich beschrieben. Das Widerstandsnetzwerk des Digital-Analog-Wandlers 5 ist in Serie mit einem Widerstand 6 in den Gegenkopplungszweig 7 eines Operationsverstärkers 8 geschaltet, der den Ausgang 8a des Operationsverstärkers 8 mit seinem invertierenden Eingang 8b verbindet. Über einen Widerstand 9 ist der invertierende Eingang 8b des Operationsverstärkers 8 außerdem mit einer Klemme 10 verbunden, an der eine Referenzspannung $U_R$ ansteht. Die Ausgangsspannung $U_A$ des Operationsverstärkers 8 steht an der Ausgangsklemme 11 der Schaltungsvorrichtung an.

Zum Rücksetzen des Zählers 3 und zum Setzen des Speichers 4 ist ein Steuerwerk 12 vorgesehen, das in Figur 1 vereinfacht gezeigt ist. Dem Steuerwerk 12 sind die drehzahlfrequenten Impulse eines Impulsgebers 13, beispielsweise eines Rotorlagegebers zugeführt, der mit der Welle einer elektrischen Drehfeldmaschine 14 mechanisch gekoppelt ist. Das Steuerwerk 12 enthält eine monostabile Kippstufe 15, deren Eingang 15a die drehzahlfrequenten Impulse zugeführt sind. Der Ausgang 15b der monostabilen Kippstufe 15 ist mit dem invertierenden Eingang 2c des UND-Gatters 2 und mit einem Eingang 16a eines weiteren UND-Gatters 16 verbunden. Außerdem ist dem Eingang 15b der monostabilen Kippstufe 15 ein Verzögerungsglied 17 nachgeschaltet, das zumindest den Übergang von Null auf Eins verzögert. Der Ausgang des Verzögerungsgliedes 17 ist mit dem Setzeingang 4a des Speichers 4 und mit einem weiteren Verzögerungsglied 18 verbunden, das ebenfalls zumindest den Übergang von Null auf Eins verzögert. Der Ausgang 18a des Verzögerungsgliedes 18 liegt am zweiten Eingang 16b des UND-Gatters 16, dessen Ausgang 16c mit dem Rückstelleingang 3c des Zählers 3 verbunden ist.

Die Wirkungsweise der in Figur 1 gezeigten Schaltungsanordnung wird anhand der Diagramme der Figur 2 näher erläutert. In Figur 2 sind die drehzahlfrequenten Impulse $I_{13}$, die aus den Impulsen des Impulsgebers 13 abgeleitet sind, der Zählerstand Z des Zählers 3 und die Ausgangsspannung $U_A$ über der Zeit t aufgetragen. Der zeitliche Abstand aufeinanderfolgender Impulse $I_{13}$ ist gleich der Dauer T der Drehperiode. Von der Vorderflanke jedes Impulses $I_{13}$ wird über das Steuerwerk 12 der Zähler 3 zurückgesetzt und neu gestartet und außerdem der Zählerstand des Zählers 3 in den Speicher 4 übernommen. Auf den Ablauf dieser Steuerung wird im Zusammenhang mit Figur 3 noch näher eingegangen. Der in den Speicher 4 übernommene Zählerstand $Z_S$ ist für jede Drehperiode T in Figur 2 gestrichelt eingezeichnet. Die in den Speicher 4 übernommene Zahl $Z_S$ wird dem Digital-Analog-Wandler aufgeschaltet. Am Ausgang 5b des Digital-Analog-Wandlers 5 steht damit die Spannung $Z_S \cdot U_A$ an. Für die Ausgangsspannung des Operationsverstärkers 8 gilt damit die Beziehung

$$\frac{U_R}{R_9} = \frac{Z_S \cdot U_A}{R_6},$$

worin $R_6$ und $R_9$ die Widerstandswerte der Widerstände 6 und 9 sind. Daraus folgt für $U_A$ und die Drehfrequenz f:

$$U_A = \frac{1}{Z_S} \cdot \frac{R_6 \cdot U_R}{R_9}$$

$$= f \cdot K,$$

da $Z_S = T = \frac{1}{f}$ ist.und der Faktor $\frac{R_6 \cdot U_R}{R_9} = K$ konstant ist. Mit Hilfe des in dem Gegenkopplungszweig des Operationsverstärkers 8 geschalteten multiplizierenden Digital-Analog-Wandlers 5 wird demnach die Referenzspannung $U_R$ durch eine der Periodendauer T entsprechende Zahl $Z_S$ dividiert und man erhält eine Analogspannung $U_A$, die der Drehfrequenz f proportional ist.

Die Ansteuerung des Zählers 3 und des Speichers 4 über das Steuerwerk 12 wird anhand der Diagramme der Figur 3 näher erläutert, wo ein Impuls $I_{13}$ und Impulse $I_{15}$, $I_{17}$ und $I_{18}$ über der Zeit t aufgetragen sind. Die Impulse $I_{15}$, $I_{17}$ und $I_{18}$ stehen an den Ausgängen der monostabilen Kippstufe 15 bzw. des Verzögerungsgliedes 17 bzw. des Verzögerungsgliedes 18 an. Durch die Vorderflanke des Impulses $I_{13}$ wird die monostabile Kippstufe 15 gesetzt. Damit wird das UND-Gatter 2 gesperrt, um während einer Beruhigungszeitspanne für den Zähler 3 das Einlesen weiterer Impulse des Taktimpulsgebers 1 zu verhindern. Der Beruhigungszeitraum wird durch die Verzögerungszeit des Verzögerungsgliedes 17 bestimmt. Nach Ablauf seiner Verzögerungszeit wird der Speicher 4 mit dem Impuls $I_{17}$ gesetzt und der Zählerstand des Zählers 3 vom Speicher 4 übernommen. Mit dem nochmals verzögerten Impuls $I_{18}$ wird über das UND-Gatter 16 der Zähler 3 zurückgesetzt und beginnt nach Signalwechsel von Null auf Eins am Eingang 2c des UND-Gatters 2 für die folgende Drehperiode zu zählen.

Patentanspruch

1. Drehfrequenz-Spannungs-Umsetzer zur Ableitung einer drehfrequenzproportionalen elektrischen Spannung aus drehzahlfrequenten Impulsen eines Impulsgebers, der mit einer Drehwelle gekoppelt ist, d a d u r c h   g e - k e n n z e i c h n e t , daß der Ausgang eines Taktimpulsgebers (1) mit dem Eingang (3a) eines Zählers (3) verbunden ist, dessen Ausgang (3b) der Eingang (4a) eines Speichers (4) nachgeschaltet ist, daß der Rücksetzeingang (3c) des Zählers (3) und der Setzeingang (4a) des Speichers (4) mit dem Ausgang des Impulsgebers (13) verknüpft sind, daß der Ausgang (4b) des Speichers (4) mit dem Eingang (5a) eines Digital-Analog- Wandlers (5) verbunden ist, dessen Widerstandsnetzwerk zwischen den Ausgang (8a) und den invertierenden Eingang (8b) eines Operationsverstärkers (8) geschaltet ist, an dessen Ausgang (8a) die frequenzproportionale Spannung ($U_A$) ansteht und daß der invertierende Eingang (8b) des Operationsverstärkers (8) über einen Widerstand (9) mit einer Referenzspannungsquelle verbunden ist.

FIG 1

FIG 2

FIG 3

**Europäisches Patentamt**

## EUROPÄISCHER RECHERCHENBERICHT

| EINSCHLÄGIGE DOKUMENTE | | | KLASSIFIKATION DER ANMELDUNG (Int Cl.³) |
|---|---|---|---|
| Kategorie | Kennzeichnung des Dokuments mit Angabe, soweit erforderlich, der maßgeblichen Teile | betrifft Anspruch | |
| | US - A - 4 152 645 (R.K. BENDLER)  * Spalte 2, Zeilen 37-46; Spalte 3, Zeilen 46-68; Spalte 4, Zeilen 24-48; Abbildungen 1,2 *  -- | 1 | G 01 P   3/48 G 01 R 23/06        23/02 |
| | DE - A - 2 720 023 (SIEMENS AG)  * Seite 9, Zeilen 25-39; Seite 10, Zeilen 1-29; Abbildung 4 *  -- | 1 | |
| | IBM TECHNICAL DISCLOSURE BULLETIN, Band 18, Nr. 1, Juni 1975, Seiten 83,84 New York, U.S.A. K.F. PEZDIRTZ: "Frequency meter"  * Seiten 83,84; Abbildung *  -- | 1 | **RECHERCHIERTE SACHGEBIETE (Int. Cl.³)**  G 01 P   3/48 G 01 R 23/06        23/02 |
| | AUTOMATIK, Band 17, Nr. 6, Juni 1972, Seiten 192-193 "Digitale rechnende Messgeräte zur schnellen und genauen Messung von Drehzahl, Geschwindigkeit und Frequenz"  * Seite 192; Abbildung Seite 193 *  -- | 1 | |
| | BBC-NACHRICHTEN, Band 46, Nr. 1, 1964, Seiten 27-30 L. SEIBERT: "Genaue Drehzahlanzeige bei kontinuierlichen Drahtstrassen"  * Seite 28, Abbildung 3 *  ---- | 1 | **KATEGORIE DER GENANNTEN DOKUMENTE**  X: von besonderer Bedeutung A: technologischer Hintergrund O: nichtschriftliche Offenbarung P: Zwischenliteratur T: der Erfindung zugrunde    liegende Theorien oder    Grundsätze E: kollidierende Anmeldung D: in der Anmeldung angeführtes    Dokument L: aus andern Gründen    angeführtes Dokument &: Mitglied der gleichen Patent-    familie,  übereinstimmendes    Dokument |

Der vorliegende Recherchenbericht wurde für alle Patentansprüche erstellt.

| Recherchenort | Abschlußdatum der Recherche | Prüfer |
|---|---|---|
| Den Haag | 14-01-1981 | KUSCHBERT |

EPA form 1503.1   06.78